# EUROPEAN PATENT APPLICATION

(11) **EP 4 297 100 A1**
(43) Date of publication of application: **27.12.2023**
(21) Application number: 22180304.2
(22) Date of filing: 22.06.2022
(51) Int. Cl.: H01L 29/78, H01L 29/06, H01L 29/10, H01L 21/336

(54) **METHOD FOR PRODUCING A SEMICONDUCTOR DEVICE AND SEMICONDUCTOR DEVICE**

(71) Applicant: Hitachi Energy Ltd, 8050 Zürich (CH)
(72) Inventor: Wirths, Stephan, 8800 Thalwil (CH); Knoll, Lars, 5607 Hägglingen (CH); Mihaila, Andrei, 5415 Rieden (CH); Romano, Gianpaolo, 5400 Baden (CH)
(74) Representative: Epping - Hermann - Fischer

(57) **Abstract**

According to an embodiment, the method comprises a step of providing a semiconductor body (1) with a top side (10). A mask (2) is applied on the top side of the semiconductor body, wherein the mask comprises at least one first section (21) and at least one second section (22). The at least one second section is laterally adjacent to the at least one first section. The mask is thicker in the at least one second section than in the at least one first section. In a further step, a channel region (11) of a first conductivity type is formed in the semiconductor body (1) in the area of the at least one first section. Forming the channel region comprises implanting first-type dopants through the top side into the semiconductor body. In a further step, an auxiliary layer (3) is deposited on a lateral side (22a) of the at least one second section, said lateral side facing towards the at least one first section. Thereby, the lateral extension of the at least one second section is increased and the lateral extension of the at least one first section is reduced. In a further step, a hole is produced in the semiconductor body in the area of the first section with the reduced lateral extension so that the hole extends from the top side through the channel region.

## Description

The present disclosure relates to a method for producing a semiconductor device and a semiconductor device.

It is an object to provide an improved method for producing a semiconductor device, for example a method with a reduced number of production steps and/or a method which enables the production of smaller structures. A further object is to provide an improved semiconductor device, for example with smaller structures.

Embodiments of the disclosure relate to an improved method for producing a semiconductor device and an improved semiconductor device.

Firstly, the method for producing a semiconductor device is specified.

According to an embodiment, the method for producing a semiconductor device comprises a step of providing a semiconductor body with a top side. A mask is applied on the top side of the semiconductor body, wherein the mask comprises at least one first section and at least one second section. The at least one second section is laterally adjacent to the at least one first section. The mask is thicker in the at least one second section than in the at least one first section. In a further step, a channel region of a first conductivity type is formed in the semiconductor body in the area of the at least one first section. Forming the channel region comprises implanting first-type dopants through the top side into the semiconductor body. In a further step, an auxiliary layer is deposited on a lateral side of the at least one second section, said lateral side facing towards the at least one first section. Thereby, the lateral extension of the at least one second section is increased and the lateral extension of the at least one first section is reduced. In a further step, a hole is produced in the semiconductor body in the area of the first section with the reduced lateral extension so that the hole extends from the top side through the channel region.

The outstanding properties of wide bandgap semiconductors (WBG), for example high critical electric field and electron mobility or high frequency switching, yield a much larger Baliga's figure-of-merit compared to the commonly used silicon, making them an ideal material for power switches. This enables several applications for energy efficiency and electric transportation.

Nowadays, most commercially available power SiC-MOSFETs are based on cell designs with planar channels aligned to the Si face, i.e. at the surface of the wafer SiC (0001). However, the boost of current densities in such switches is hampered due to the junction-FET (JFET) resistance increasing with down-scaling of the injectors as well as due to the low inversion channel mobility. On the other hand, trench MOSFETs exhibiting a dry-etched U-shape channel enable the achievement of low ON-resistances because of the lack of a JFET region and a high cell density. Especially for SiC channel devices, the trench MOSFET architecture allows optimization of carrier mobility by designing the channel with respect to different crystallographic planes and increasing gate dielectric control.

Nonetheless, state-of-the-art trench cell designs do not entirely exploit the above-mentioned advantages. Despite making use of different crystallographic planes for the carrier transport, the trench pitch and width of the cells are still rather large, thus prohibiting ultimately scaled cell densities and, thus, high current densities of the devices.

The herein disclosed method enables a self-aligned channel implantation and trench etch and, thus, replaces two separate lithography steps. Consequently, less production steps are needed and smaller structures can be produced. The method is suited for the production of different semiconductor devices, like MOSFTs or IGBTs or JFETs or MISFETs.

The semiconductor body is, for example, based on Si, SiC, GaN, Ga₂O₃. The semiconductor body may be based on a wide bandgap material. The semiconductor body may comprise a doped substrate and a doped drift layer on top of the substrate. The top side of the semiconductor body may be at least partially formed by the drift layer. For example, the substrate has a higher doping concentration than the drift layer. The substrate and the drift layer may be of the same conductivity type. Both may be either n-doped or p-doped.

In the step of providing the semiconductor body, the top side of the semiconductor body may be a flat surface without interruptions or recesses or holes.

The mask may be produced with the help of a lithography process. For example, the mask comprises a photoresist. In the at least one second section, the mask is thicker than in the at least one first section. This may mean that the thickness of the mask in the at least one first section is zero so that, for example, the top side of the semiconductor body is exposed in the area of the at least one first section. Alternatively, the mask may have a thickness in the at least one first section which is greater than zero but still smaller than in the at least one second section. In both cases, a step is formed between the at least one first section and the at least one second section. This step forms a lateral side of the second section facing towards the at least one first section.

The thickness of the mask is measured in a direction perpendicular to the top side. "Thickness" herein means the average of maximum thickness. For example, the thickness of the mask in the at least one second section is at least 2 times or at least 5 times or at least 10 times or at least 100 times greater than in the at least one first section.

The mask comprises at least one first section, i.e. one or more first sections, and at least one second section, i.e. one or more second sections. All features disclosed herein for one first section are also disclosed for all first sections and, likewise, all features disclosed herein for one second section are also disclosed for all second sections. For the sake of simplicity, the expression "the at least one" is herein also simply referred to as "the".

For example, the mask comprises one second section which forms a web and several first sections, each of which lies within a mesh of the web. Alternatively, the mask may comprise one first section which forms a web and several second sections, each of which lies within a mesh of the web. A further alternative is that the mask comprises several first sections and several second sections wherein each first section lies laterally between two second sections.

The at least one first section is laterally adjacent to the at least one second section. Particularly, the at least one second section adjoins the at least one first section in lateral direction. The step between the first and the second section indicates the border between the first and the second section, for example. The second section may laterally completely surround the at least one first section. Alternatively, the first section may lie between two second sections in a first lateral direction. A lateral direction is herein understood as a direction parallel to the top side and/or parallel to the main extension plane of the semiconductor body.

The step of forming the channel region is performed after the step of applying the mask on the top side. Forming the channel region comprises the implantation of first-type dopants through the top side of the semiconductor body. The first-type dopants are either p-type dopants or n-type dopants. Second-type dopants are herein different to the first-type dopants, i.e. either n-type dopants or p-type dopants. For example, the first-type dopants are boron and second-type dopants are arsenic or phosphorus.

Forming the channel region may further comprise an annealing step which is performed after the implantation of the first-type dopants. During the annealing step, the implanted first-type dopants further diffuse into the semiconductor body so that the channel region expands into the semiconductor body.

The channel region is of a first conductivity type. In the case of the first-type dopants being p-type dopants, the first conductivity type is hole conduction. That is, the channel region is p-doped. In the case of the first-type dopants being n-type dopants, the first conductivity type is electron conduction, i.e. the channel region is n-doped. A second conductivity type is herein different to the first conductivity type.

The channel region is formed in the area of the at least one first section, i.e. under the at least one first section. During implantation, the dopants may hit the mask over its whole lateral extension, i.e. also in the area of the at least one second section. However, due to the greater thickness of the mask in the at least one second section, less dopants are implanted into the semiconductor body in the area of the second section. The amount of first-type dopants implanted in the area of the second section is, for example, not sufficient to form a region of the first conductivity type under the second section.

The channel region extends from the top side into the semiconductor body (depth of the channel region), for example by at least 50 nm and/or at most 1 µm.

The step of depositing an auxiliary layer on the lateral side of the at least one second section is performed after forming the channel region. As mentioned above, the lateral side of the at least one second section may be formed by a step between the at least one second section and the at least one first section. Thus, the lateral side extends obliquely, e.g. perpendicularly or almost perpendicularly, to the top side.

Due to the auxiliary layer, the width or lateral extension, respectively, of the second section increases whereas the width or lateral extension, respectively, of the first section is reduced. In other words, due the deposition of the auxiliary layer on the lateral side of the mask (also referred to as initial mask), the mask is supplemented by the deposited auxiliary layer and, thus, is transformed into a new mask which comprises the initial mask and the deposited auxiliary layer and which has a narrower/smaller first section and a broader/larger second section.

The thickness of the auxiliary layer on the lateral side of the at least one second section is, for example, at least 50 nm and or at most 1 µm. Therefore, the lateral extension of the at least one second section increases at least by this thickness, for example by about two times this thickness, and the lateral extension of the at least one first section reduces at least by this thickness, for example by about two times this thickness.

The material of the auxiliary layer is, for example, different from the material of the initial mask. For example, the auxiliary layer comprises or consists of SiO₂ or SiN or polysilicon.

The step of producing a hole in the semiconductor body is performed after the application of the auxiliary layer. The hole is produced in the area of the first section with the reduced lateral extension. During the production of the hole, the semiconductor body below the second section with the increased lateral extension may be protected by the second section with the increased lateral extension so that the hole is indeed only formed in the area of the first section with the reduced lateral extension.

Due to the reduced lateral extension of the first section, the produced hole has a smaller lateral extension or width, respectively, than the previously formed channel region. Accordingly, the hole is formed through the channel region For example, the hole laterally adjoins the channel region. For instance, the hole is laterally completely surrounded by the channel region or the channel region adjoins the hole on both sides with respect to the first lateral direction.

For example, the produced hole projects deeper into the semiconductor body than the channel region, such as at least 1.5 times deeper. By way of example, the depth of the hole is at least 500 nm and/or at most 2 µm.

According to a further embodiment, after forming the channel region and before depositing the auxiliary layer, a further auxiliary layer is deposited on the lateral side of the at least one second section which increases the lateral extension of the at least one second section and reduces the lateral extension of the at least one first section. Since the further auxiliary layer is deposited before the auxiliary layer, the further auxiliary layer is herein also referred to as first auxiliary layer and the auxiliary layer is, accordingly, herein also referred to as second auxiliary layer.

Thus, during the method, the lateral extension of the second section of the mask may be increased two times and the lateral extension of the first section of the mask may be reduced two times. Or, in other words, the initial mask is transformed twice into a respective new mask with the first section becoming narrower/smaller and the second section becoming broader/larger each time.

The thickness of the further auxiliary layer on the lateral side of the at least one second section may be in the same range as the thickness of the auxiliary layer on the lateral side. The further auxiliary layer may be of a different material than the auxiliary layer and/or the mask. For example, the further auxiliary layer comprises or consists of SiO₂ or SiN or polysilicon.

According to a further embodiment, after depositing the further auxiliary layer and before depositing the auxiliary layer, a contact region of the second conductivity type is formed in the semiconductor body in the area of the first section. The contact region is formed such that it lies between the channel region and the top side of the semiconductor body. The formation of the contact region comprises implanting second-type dopants through the top side into the semiconductor body.

The formation of the contact region may comprise an annealing process after the implantation of the second-type dopants. In the annealing process, the second-type dopants further diffuse into the semiconductor body so that the contact region further expands into the semiconductor body.

The contact region is at least partially formed out of the previously formed channel region. Thus, the amount of implanted second-type dopants is sufficient to convert a part of the channel region being of the first conductivity type into the second conductivity type.

Since, during implantation of the second-type dopants, the lateral extension of the first section is reduced compared to the lateral extension of the first section during implantation of the first-type dopants, the contact region has a smaller lateral extension than the channel region. Accordingly, in lateral directions, the contact region is surrounded by the channel region or the channel region adjoins the contact region on both sides with respect to the first lateral direction.

The depth of the contact region is, for example, smaller than the depth of the channel region so that the contact region lies between the channel region and the top side. In other words, in vertical direction, perpendicular to the top side, the contact region is arranged between the channel region and the top side.

According to a further embodiment, the hole is formed through the contact region. For example, the hole laterally adjoins the contact region. Since the lateral extension of the first section is smaller during the formation of the hole than the lateral extension of the first section during the implantation of the second type dopants, the lateral extension of the hole is smaller than the lateral extension of the contact region. For example, the hole is laterally surrounded by the contact region or the contact region laterally adjoins the hole on both sides with respect to the first lateral direction. For example, in the first lateral direction, the contact region is arranged between the hole and the channel region.

With the formation of the hole, the channel region and/or the contact region formed in the area of the at least one first section may be divided into two channel regions and/or contact regions. All features disclosed herein and in the following with respect to one channel region or one contact region in the area of the at least one first section are also disclosed for the two contact regions or two channel regions in the area of the at least one first section.

According to a further embodiment, the auxiliary layer is deposited by a conformal, i.e. undirected, deposition process. Due to this, the lateral side of the at least one second section, the top side of the at least one second section and the area of the first section are covered by the auxiliary layer. For example, in the area of the first section, the top side of the semiconductor body is covered by the auxiliary layer. The auxiliary layer may be deposited by Chemical Vapour Deposition, CVD for short, for example.

According to a further embodiment, after deposition of the auxiliary layer, a directed material removal process is applied by which the auxiliary layer is removed more in the area of the first section and at the top side of the second section than at the lateral side of the at least one second section. The removal process may be an etching process, like a dry etching process, e.g. a plasma etching process. The directed material removal process is also known as anisotropic material removal process.

After the material removal process, the lateral side of the at least one second section is still covered by at least the rest of the previously deposited auxiliary layer. The area of the at least one first section, now with the reduced lateral extension, and/or the top side of the at least one second section, however, may be exposed after the directed material removal process. The hole is, for example, formed after performing the directed material removal process. For instance, the above specified thickness of the auxiliary layer on the lateral side concerns the thickness after the material removal process.

The same as is disclosed for the auxiliary layer with respect to the conformal deposition process and the subsequent directed material removal process may also be carried out for the further auxiliary layer. The implantation of the second-type dopants is, for example, carried out after the directed material removal process applied to the further auxiliary layer.

According to at least one embodiment, a protection layer is deposited onto the semiconductor body at least in the area of the at least one first section before depositing the auxiliary layer and/or before depositing the further auxiliary layer. The protection layer is configured to protect the semiconductor body when removing the (further) auxiliary layer by means of the directed material removal process. For example, the protection layer is an etch stop layer preventing an etchant to reach the semiconductor body.

According to a further embodiment, before applying the mask, the semiconductor body is of the second conductivity type at least at the top side. For example, the whole top side is of the second conductivity type. Particularly, the drift layer of the semiconductor body may be of the second conductivity type. The substrate may also be of the second conductivity type.

According to a further embodiment, during implantation of the first-type dopants, the at least one second section protects the semiconductor body below from the first-type dopants so that the semiconductor body remains of the second conductivity type at the top side in the area of the at least one second section. In other words, the amount of first-type dopants reaching into the semiconductor body in the area of the at least one second section is not sufficient to convert the conductivity type of the semiconductor body.

According to a further embodiment, the method further comprises a step of forming an electrically isolating layer at surfaces of the hole. The isolating layer is, e.g., SiO₂. The formation of the isolating layer may be done by filling an electrically isolating material into the hole or by oxidation of the surfaces of the hole. The surfaces of the hole are, in particular, lateral surfaces and/or a bottom surface formed by the semiconductor body and delimiting the hole.

According to a further embodiment, the method further comprises forming a gate electrode on and/or in the at least one hole such that the gate electrode is electrically isolated from the semiconductor body by the electrically isolating layer. The gate electrode may comprise or consist of at least one of: a metal, like Cu, Al, Au, Ag or an alloy thereof, or highly-doped polysilicon.

The formation of the electrically isolating layer and/or the gate electrode may be done with the mask still being on the top side of the semiconductor body.

According to a further embodiment, the method comprises a step of removing the mask. During removal of the mask, the auxiliary layer and/or the further auxiliary layer, together with the initial mask, may be removed.

According to a further embodiment, the method comprises the step of forming a main electrode on the top side so that the main electrode adjoins and is electrically connected to the semiconductor body in the area laterally adjacent to the at least one hole. Particularly, this step is carried out after removing of the mask so that the main electrode adjoins the top side of the semiconductor body in the area where the at least one second section of the mask has previously covered the top side.

The main electrode is, e.g., of a metal, like Cu, Al, Au, Ag or an alloy thereof. For example, the main electrode is electrically isolated from the gate electrode, for instance by means of the electrically isolating layer. The main electrode may adjoin and may be in electrical contact to the contact region and the channel region. For example, an ohmic contact is formed between the main electrode and the contact region and/or the channel region.

According to a further embodiment, the main electrode adjoins at least one diode region of the semiconductor body at the top side. The diode region is of the second conductivity type. For example, the diode region is a region of the semiconductor body which has previously been covered and, accordingly, protected by the at least one second section of the mask. The diode region may be formed by the drift layer. For example, the diode region and the main electrode together form a Schottky diode, also referred to as a JBS diode. Thus, a Schottky contact is formed between the main electrode and the diode region.

In the first lateral direction, the contact region and the channel region may be arranged between the hole and the diode region. The diode region may adjoin the channel region in the first lateral direction.

According to a further embodiment, before applying the mask a further mask is applied onto the top side of the semiconductor body. The further mask can also comprise a photoresist and may be formed by lithography.

According to a further embodiment, at least one plug region being of the first conductivity type is formed in the semiconductor body with help of the further mask. Forming the at least one plug region may also comprise implanting first-type dopants through the top side into the semiconductor body. After the implantation, an annealing process may be performed so that the plug region further expands into the semiconductor body.

According to a further embodiment, the at least one plug region adjoins the top side and is at least partially formed in the area which is subsequently covered by the at least one second section of the mask.

The plug region may also be arranged in the area of the first section of the subsequently applied mask. For example, during implantation of the second-type dopants, the plug region in the area of the first section of the mask is converted into the second conductivity type and thus becomes part of the contact region.

According to a further embodiment, the doping concentration in the at least one plug region is greater than in the channel region. When referring to doping concentrations of different regions, an average or maximum doping concentration of the regions is meant in each case.

For example, the at least one plug region has a doping concentration which is at least one order of magnitude greater than the doping concentration of the channel region. The doping concentration in the plug region is, for example, between 10¹⁸ cm⁻³ and 10¹⁹ cm⁻³. The doping concentration in the channel region is, for example, between 10¹⁶ cm⁻³ and 10¹⁸ cm⁻³.

The doping concentration of the contact region is, for example, greater than the doping concentration of the drift layer and/or of the diode region and/or of the channel region, e.g. by at least one order of magnitude. The doping concentration in the contact region is, for example, between 10¹⁸ cm⁻³ and 10¹⁹ cm⁻³. The doping concentration of the drift layer and/or of the diode region is, for example, between 10¹⁵ cm⁻³ and 10¹⁷ cm⁻³ depending on the voltage class of the semiconductor device.

According to a further embodiment, the mask comprises a plurality of stripe-like first sections and a plurality of stripe-like second sections. For example, a first section is formed between each two second sections. Likewise, a second section may be formed between each two first sections. For example, the first and second sections are arranged behind each other in the first lateral direction in an alternating manner.

The first and the second sections are stripe-like, i.e. elongated. For example, the second sections are formed as ribs. Main extension directions of the first and second sections may run parallel to each other. For example, the first and second sections each extend in a second lateral direction, being perpendicular to the first lateral direction.

According to a further embodiment, a channel region and a hole are formed in the area of several or each of the first sections. Each channel region may be formed stripe-like and each hole may be formed as a trench. The stripe-like channel regions and the trenches may all extend in the second lateral direction. When forming the trenches, the stripe-like channel regions are each divided into two stripe-like channel regions spaced apart from each other in the first lateral direction.

Likewise, in the area of each first section, a stripe-like contact region may be formed. The stripe-like contact regions extend in the second lateral direction, for example. When forming the trenches, the stripe-like contact regions are each divided into two stripe-like contact regions spaced apart from each other in the first lateral direction.

All features disclosed so far and in the following for the formation of the channel region and/or the contact region and/or the hole in in the area of the at least one first section are also disclosed for the formation of all other channel regions and/or contact regions and/or holes in the area of the further first sections of the mask.

According to a further embodiment, a plurality of plug regions is formed. All features disclosed in connection with the at least one plug region are also disclosed for all other plug regions.

According to a further embodiment, each plug region is formed stripe-like, i.e. is elongated.

According to a further embodiment, the plug regions extend obliquely to the channel regions. For example, the plug regions extend perpendicularly to the channel regions. The plug regions may extend in the first lateral direction and may be spaced from each other in the second lateral direction. For example, all plug regions extend parallel to each other.

Next, the semiconductor device is specified. The semiconductor device may be produced with the method according to any one of the embodiments disclosed herein. Therefore, all features disclosed for the method are also disclosed for the semiconductor device and vice versa.

According to an embodiment, the semiconductor device comprises a semiconductor body with a top side. At least one hole extends from the top side into the semiconductor body. The at least one hole delimits an active area of the semiconductor body in a first lateral direction, parallel to the top side. The active area comprises at least one channel region being of a first conductivity type and at least one contact region being of a second conductivity type. The at least one channel region and the at least one contact region adjoin the at least one hole in the first lateral direction. The at least one contact region is embedded in the at least one channel region such that in vertical direction, perpendicular to the top side, the at least one contact region is arranged between the top side and the at least one channel region and such that the at least one contact region adjoins the top side in vertical direction. The width of the active area measured in the first lateral direction is at most 3 times as large as the depth of the at least one hole measured in vertical direction.

Active areas with such an aspect ratio (width/depth) can be produced with the method described herein. For example, the width of the active area is at most 2 times as large as the depth of the at least one hole or is at most as large as the depth of the at least one hole.

The active area of the semiconductor device is the area in which charge carriers are transported during operation. For example, the active area is formed between two holes and delimited in first lateral direction by the two holes. The active area is, for example, a contiguous area of the semiconductor body.

The semiconductor device may comprise several active areas laterally spaced from each other by one or more holes. All features disclosed for one active area are also disclosed for all other active areas.

According to a further embodiment, the width of the active area is at most 3 µm or at most 2.5 µm or at most 2 µm or at most 1.5 µm or at most 1 µm.

According to a further embodiment, the semiconductor device further comprises a main electrode on the top side in the active area.

According to a further embodiment, the active are comprises at least diode region, wherein said at least one diode region is of the second conductivity type. The at least one diode region may adjoin the top side of the semiconductor body in vertical direction.

According to a further embodiment, the main electrode adjoins and is in electrical contact with the at least one contact region. Additionally, the main electrode may adjoin and may be in electrical contact with the at least one diode region and/or the at least one channel region.

According to a further embodiment, surfaces of the at least one hole are at least partially covered by an electrically isolating layer. The surfaces of the hole are formed by the semiconductor body. For example, lateral surface(s) and a bottom surface of the hole are covered by the electrically isolating layer.

According to a further embodiment, a gate electrode is formed on and/or in the at least one hole and is electrically isolated from the semiconductor body by the isolating layer.

According to a further embodiment, the active area comprises at least one plug region, wherein the at least one plug region is of the first conductivity type and adjoins the top side. For example, the at least one plug region has a higher doping concentration than the at least one channel region.

According to a further embodiment, the semiconductor device is a power semiconductor device. For example, the semiconductor device is a MOSFET or an IGBT or a JFET or a MISFET. A further main electrode may be applied on a bottom side of the semiconductor body, wherein the bottom side is opposite to the top side. The power semiconductor device may be configured for a voltage difference between the main electrode and the further main electrode of at least 1 kV, e.g. at least 1.2 kV or at least 3.3 kV.

In case of a MISFET, JFET or MOSFET, the contact region is also referred to a source region. In case of an IGBT, the contact region is also referred to as emitter region.

According to a further embodiment, the semiconductor device comprises a plurality of holes each formed as a trench. The trenches are spaced apart from each other in a first lateral direction. Each trench extends in the second lateral direction. The first and the second lateral direction are, for example, perpendicular to each other.

According to a further embodiment, the semiconductor device comprises a plurality of active areas, wherein each active area is arranged between a pair of trenches. Thus, in the first lateral direction, one active area is formed between each pair of trenches.

According to a further embodiment, each active area comprises at least two elongated channel regions, e.g. stripe-like channel regions. The channel regions extend in the second lateral direction. Furthermore, each active area comprises at least two elongated contact regions, e.g. stripe-like contact regions. Each contact region extends in the second lateral direction. The contact regions may be spaced apart from each other in the first lateral direction. Likewise, the channel regions may be spaced apart from each other in the first lateral direction.

The lengths of the trenches, of the contact regions and/or of the channel regions measured along the second lateral direction may all be the same.

According to a further embodiment, the channel regions and contact regions of each active area each adjoin a trench delimiting the active area. Thus, in each active area, one contact region and one channel region adjoin a trench delimiting the active area on one side with respect to the first lateral direction and a further channel region and a further contact region adjoin a trench delimiting the active area on the other side with respect to the first lateral direction.

According to a further embodiment, the width of an active area is the distance between the two trenches delimiting the active area in the first lateral direction.

Hereinafter, the method for producing a semiconductor device and the semiconductor device will be explained in more detail with reference to the drawings on the basis of exemplary embodiments. The accompanying figures are included to provide a further understanding. In the figures, elements of the same structure and/or functionality may be referenced by the same reference signs. It is to be understood that the embodiments shown in the figures are illustrative representations and are not necessarily drawn to scale. In so far as elements or components correspond to one another in terms of their function in different figures, the description thereof is not repeated for each of the following figures. For the sake of clarity, elements might not appear with corresponding reference symbols in all figures.

Figures 1 and 2 show flowcharts of exemplary embodiments of the method for producing a semiconductor device,

Figures 3 to 18 show different positions during an exemplary embodiment of the method for producing a semiconductor device,

Figure 19 shows an exemplary embodiment of the semiconductor device.

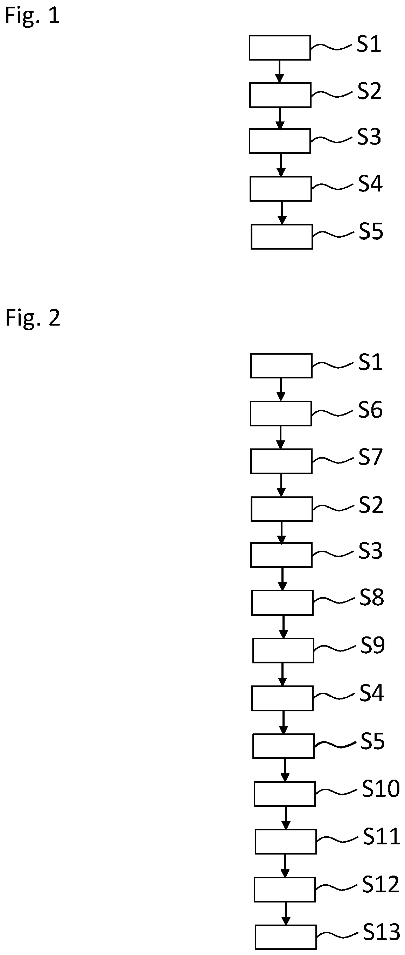

Figure 1 shows a flowchart of a first exemplary embodiment of the method for producing a semiconductor device. In a step S1, a semiconductor body with a top side is provided. Then, in a second step S2, a mask is applied on the top side, wherein the mask comprises at least one first section and at least one second section laterally adjacent to the at least one first section. The mask is thicker in the at least one second section than in the at least one first section. In a step S3, at least one channel region of a first conductivity type is formed in the semiconductor body in the area of the at least one first section, wherein forming the channel region comprises implanting first-type dopants through the top side into the semiconductor body. In a step S4, an auxiliary layer is deposited on a lateral side of the at least one second section facing towards the at least one first section which increases the lateral extension of the at least one second section and reduces the lateral extension of the at least one first section. In a step S5, a hole is produced in the semiconductor body in the area of the at least one first section with the reduced lateral extension so that the at least one hole extends from the top side through the channel region.

Figure 2 shows a flowchart of a second exemplary embodiment of the method for producing a semiconductor device. Steps S1 to S5 are the same as in the first exemplary embodiment. After step S1, a step S6 is performed in which a further mask is applied onto the top side of the semiconductor body. In a step S7, at least one plug region being of the first conductivity type is formed in the semiconductor body with help of the further mask. Then, the further mask is removed and steps S2 and S3 are performed. After the step S3 in which the channel region is formed, a step S8 is performed in which a further auxiliary layer is deposited onto the lateral side of the at least one second section of the mask which increases the lateral extension of the at least one second section and reduces the lateral extension of the at least one first section. After that, in a step S9, a contact region of a second conductivity type is formed in the semiconductor body in the area of the first section so that the contact region lies between the channel region and the top side of the semiconductor body. Forming the contact region comprises implanting second-type dopants through the top side. The contact region is of a second conductivity type. After that, steps S4 and S5 are performed. After step S5 in which the hole is formed, an electrically isolating layer is formed on surfaces of the at least one hole in a step S10. Then, in a step S11, a gate electrode is formed on and/or in the at least one hole with the gate electrode being electrically isolated from the semiconductor body by the electrically isolating layer. In a step S12, the mask is removed and in a step S13, a main electrode is formed on the top side of the semiconductor body.

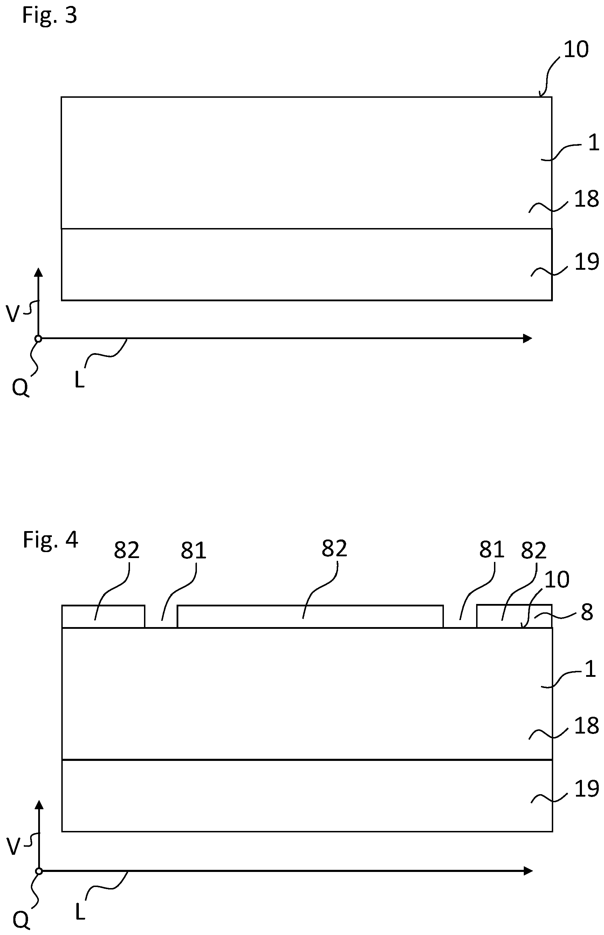

Figures 3 to 18 now show an exemplary embodiment of the method for producing a semiconductor device on the basis of various positions during the method. In this exemplary embodiment, the first-type dopants are p-type dopants and, accordingly, the first conductivity type is hole conduction. The second type-dopants are n-type dopants and, accordingly, the second conductivity type is electron conduction. However, the method can be also performed with the first-type dopants being n-type dopants and the second-type dopants being p-type dopants.

In figure 3, a semiconductor body 1 is provided. The semiconductor body 1 is, for example, based on a wide bandgap material, like SiC. The semiconductor body 1 comprises an n-doped substrate 19 and an n-doped drift layer 18 on top of the substrate 19. The doping concentration in the substrate 19 is larger than in the drift layer 18. For example, in the drift layer 18, the doping concentration is between 10¹⁵ cm⁻³ and 10¹⁷ cm⁻³. The drift layer 18 forms a top side 10 of the semiconductor body 1.

Figure 3 also indicates the different directions used herein. Lateral directions are herein defined as directions parallel to the top side 10 or the main extension plane of the semiconductor body 1, respectively. In figure 3, a first lateral direction Q is perpendicular to the paper plane and a second lateral direction L is parallel to the paper plane. A vertical direction V is a direction perpendicular to the top side 10 or the main extension plane, respectively, and is also parallel to the paper plane in figure 3.

Figure 4 shows a position in the method, in which a first mask 8, herein also referred to as further mask 8, is applied on the top side 10 of the semiconductor body 1. The mask 8, comprises first sections 81 in which the top side 10 is exposed and second sections 82 in which the top side 10 is covered by mask material. For example, the mask 8 is produced with the help of photolithography. The mask material of the first mask 8 may be a photoresist.

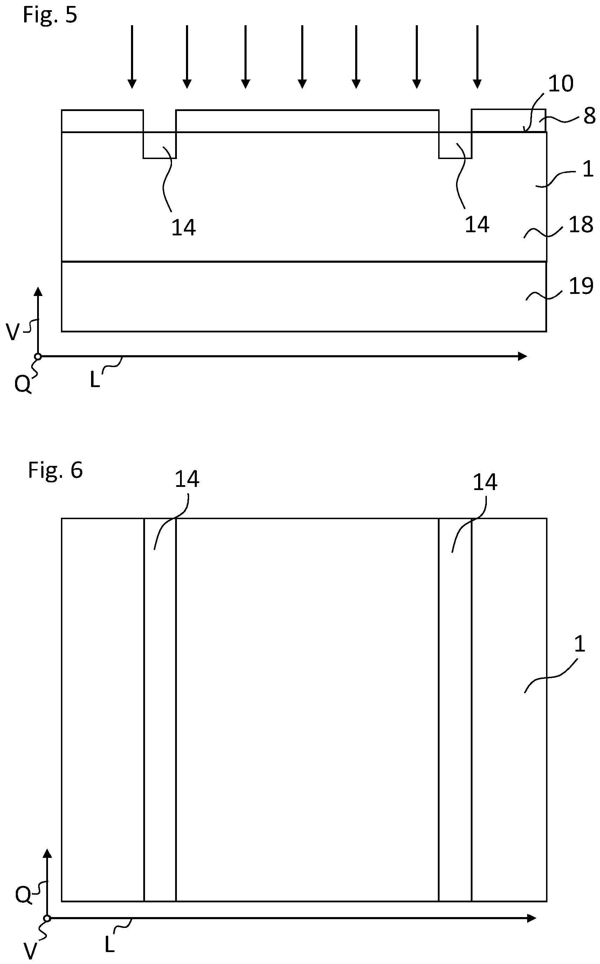

Figure 5 shows a position in which first-type dopants, namely p-type dopants, like boron, are implanted through the top side 10 into the semiconductor body 1. Thereby, plug regions 14 are produced in the area of the first sections 81 of the first mask 8. The plug regions 14 are, accordingly, p-doped regions. Thus, the amount of implanted p-type dopants is so large that the previously n-doped semiconductor material below the first sections 81 of the first mask 8 is converted into p-doped semiconductor material.

A certain amount of p-type dopants may reach through the second sections 82 of the first mask 8 and may be accommodated in the semiconductor body 1 below the second sections 82. However, the shielding or protection by the second sections 82 is so efficient that the amount of p-type dopants reaching into the semiconductor body 1 is not sufficient to convert the n-doped semiconductor material into p-doped material. As a consequence, the plug regions 14 are only formed in the area of the first sections 81 of the first mask 8. In the area of the second sections 82, the semiconductor body 1 remains n-doped.

The formation of the plug regions 14 may comprise an annealing process after or during the implantation process so that the implanted p-type dopants further drift into the semiconductor body 1, due to which the plug regions 14 further expand. The doping concentration in the plug regions 14 after annealing is, for example, between 10¹⁸ cm⁻³ and 10¹⁹ cm⁻³.

In contrast to what is shown in figure 5, the plug regions 14 may also be formed in trenches. For this purpose, trenches may be formed in the semiconductor body 1 in the area of the first sections 81 and then the p-type dopants may be implanted into the semiconductor body 1 in the region of the trenches. In this way it is achieved that the plug regions 14 extend deeper into the semiconductor body 1.

In figure 6, the semiconductor body 1 is shown in plan view on the top side 10 after the first mask 8 has been removed. As can be seen here, the plug regions 14 are elongated, stripe-like regions which each extend in the first lateral direction Q and which are spaced apart from each other in the second lateral direction L.

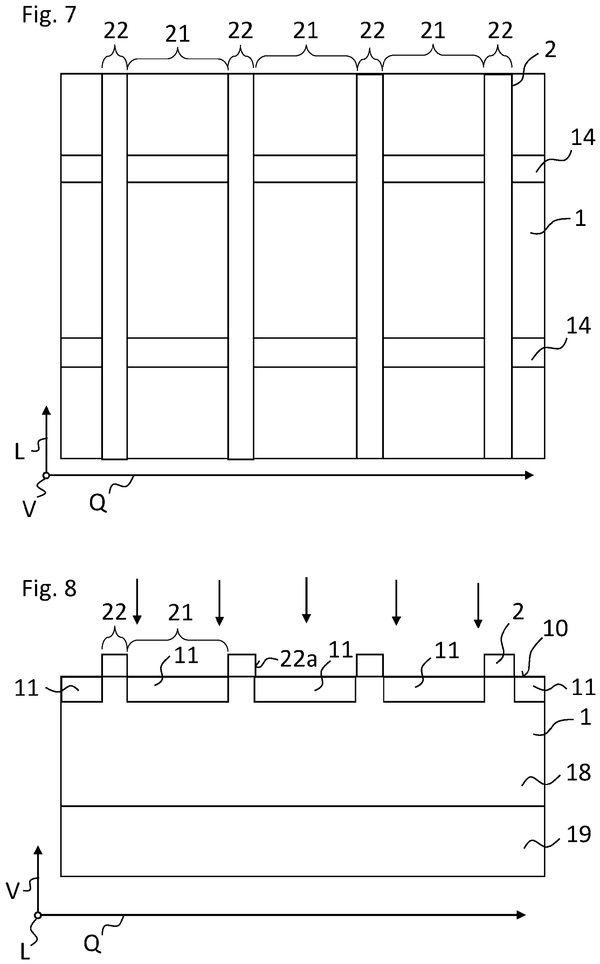

Figure 7 shows a further position of the method. Again, a plan view on the top side 10 of the semiconductor body 1 is shown. In figure 7, a second mask 2, herein also simply referred to as mask 2, is applied onto the top side 10 of the semiconductor body 1. The second mask 2 comprises first sections 21 and second sections 22. In the first sections 21, the top side 10 of the semiconductor body 1 is exposed. In the second sections 22, however, the top side 10 is covered by mask material. The second mask 2 may again be produced by photolithography. The mask material may be a photoresist.

The first 21 and the second 22 sections are elongated, stripe-like structures, each of which extends along the second lateral direction L. In the first lateral direction Q, the first and the second sections 22 are arranged in an alternating manner.

Figure 8 shows the semiconductor body 1 again in cross-sectional view, but now in rotated view compared to figures 3 to 5 with the second lateral direction L being perpendicular to the paper plane and the first lateral direction Q being parallel to the paper plane.

In figure 8 a position is shown in which first-type dopants, namely p-type dopants, are implanted through the top side 10. In the first sections 21, the semiconductor body 1 is not protected by the mask 2. Therefore, the amount of p-type dopants being injected into the semiconductor body 1 is larger in the area of the first sections 21 than in the area of the second sections 22. As a consequence of this, channel regions 11 are formed in the area of the first sections 21. The channel regions 11 are of the first conductivity type, namely hole conducting or p-doped, respectively. In other words, the amount of implanted p-type dopants is sufficient to convert the previously n-doped semiconductor material in the area of the first section 21 into p-doped semiconductor material. In the area of the second section 22, the amount of implanted p-type dopants is not sufficient to change the doping type. The formation of the channel regions 11 may again comprise an additional annealing process.

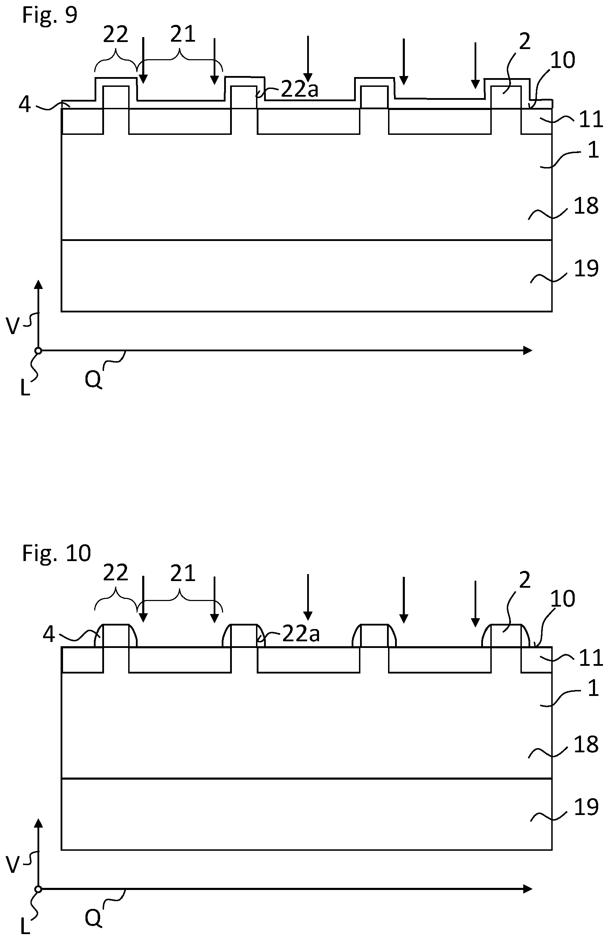

Figure 9 shows a position of the method in which a first auxiliary layer 4, herein also referred to as further auxiliary layer, is deposited onto the initial mask 2. Thereby, the first auxiliary layer 4 covers the top side of the semiconductor body 1 in the area of the first sections 21, the top side of the initial mask 2 in the area of the second sections 22 and also the lateral sides 22a of the second sections 22. The lateral sides 22a extend perpendicularly to the top side 10 and are each formed by a step between a first section 21 and a second section 22 of the initial mask 2. For depositing the first auxiliary layer 4, a conformal or undirected, respectively, deposition process, like CVD, is used. The first auxiliary layer 4 comprises or consists of, for example, SiN or SiO₂.

Figure 10 shows a further position in the method, in which a directed material removal process, like dry etching, is used to remove the material of the first auxiliary layer 4 in the area of the first sections 21 and on the top sides of the second sections 22. The directed material removal process does not, or does not completely, remove the material of the first auxiliary layer 4 on the lateral sides 22a of the second sections 22. As a consequence of this, at least a part of the first auxiliary layer 4 remains on the lateral sides 22a of the second sections 22. Thus, the second sections 22 become effectively broader, i.e. their lateral extensions in the first lateral direction Q are increased, wherein the first sections 21 become effectivity narrower, i.e. their lateral extension in the first lateral direction Q is reduced. The thickness of the remaining part of the first auxiliary layer 4 on the lateral sides 22a of the second sections 22 is, e.g., at least 100 nm and at most 1 µm.

Accordingly, the widths of the second sections 22 are each increased by 2 times this thickness, whereas the widths of the first sections are each reduced by 2 times this thickness.

Before applying the further auxiliary layer 4, a protection layer (not shown), e.g. an etch stop layer, may be applied to the top side 10 of the semiconductor body 1. This protection layer may protect the semiconductor body 1 in the area of the first section from being attacked during the directed material removal process.

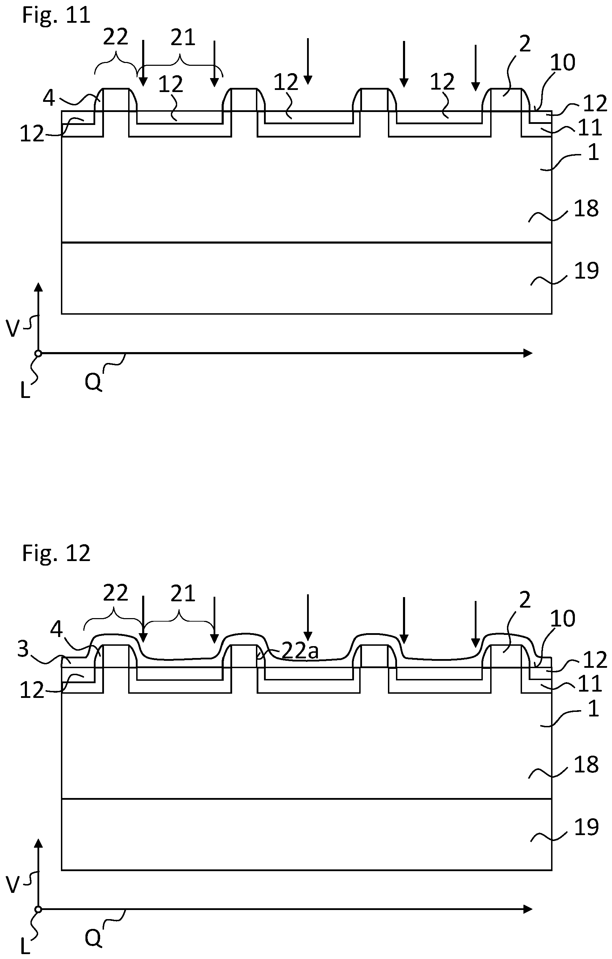

Figure 11 shows a position of the method in which second-type dopants, namely n-type dopants, are implanted through the top side 10 into the semiconductor body 1. Thereby, contact regions 12 are formed in the area of the first sections 21 having the reduced lateral extension. Due to the reduced lateral extension of the first sections 21 compared to the implementation of the first-type dopants for forming the channel regions 11, the contact regions 12 are narrower, i.e. have a smaller lateral extension in the first lateral direction Q, than the channel regions 11. Also here, the formation of the contact regions 12 may additionally comprise an annealing step which is not shown.

The contact regions 12 are formed out of a part of the previously formed channel regions 11 and are of the second conductivity type, namely electron conduction or n-doped, respectively. Thus, the amount of implanted n-type dopants is sufficient to convert the respective part of the channel regions 11 from p-doped to n-doped. For example, the doping concentration in the contact regions 12 is between 10¹⁸ cm⁻³ and 10¹⁹ cm⁻³.

As can be further seen in figure 11, the depths of the contact regions 12 are smaller than the depths of the channel regions 11, wherein the depths are measured in vertical direction V. Thus, the contact regions 12 are formed between the top side 10 and the channel regions 11 in vertical direction V.

Figure 12 shows a position of the method in which a second auxiliary layer 3, herein also simply referred to as auxiliary layer 3, is deposited onto the top side 10 of the semiconductor body 1 by means of a conformal deposition method. The auxiliary layer 3 covers the top side 10 in the area of the first sections 21, top sides of the second sections 22 and the lateral sides 22a of the second sections 22. The second auxiliary layer 3 may be of a different material than the first auxiliary layer 4. For example, the second auxiliary layer 3 is formed of SiN or SiO₂.

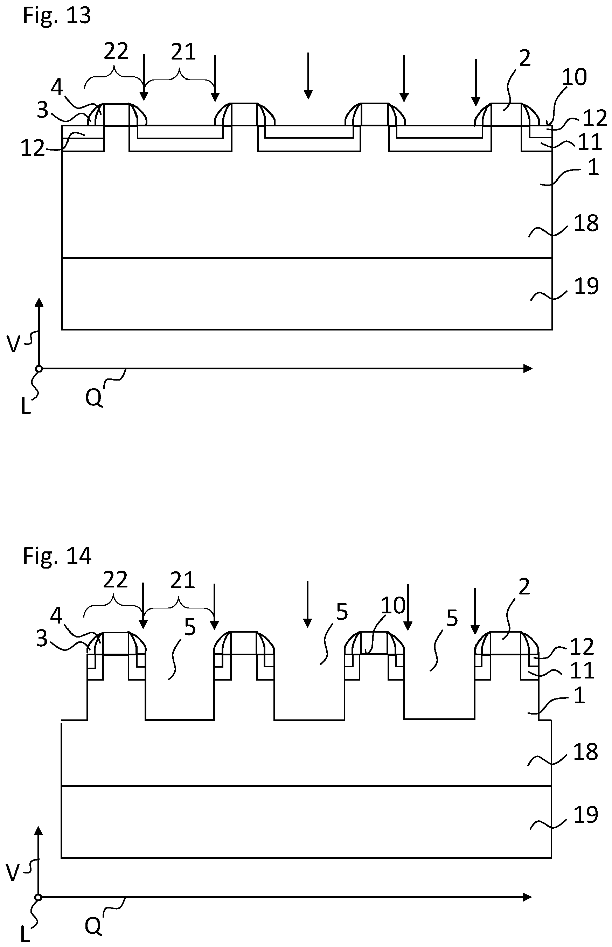

In the position shown in figure 13, a directed material removal process, like dry etching, is used to remove the second auxiliary layer 3 in the area of the first sections 21 and on the top sides of the second sections 22. Due to the directed method, a rest of the second auxiliary layer 3 remains on the lateral sides 22a of the second sections 22 so that the widths of the second sections 22 are effectively increased again, wherein the widths of the first sections 21 are effectively reduced again. The thickness of the rest of the second auxiliary layer 3 on the lateral sides 22a may be in the same region as of the first auxiliary layer 4.

In the position of figure 14, holes 5 in the form of trenches are etched into the semiconductor body 1 in the area of the first sections 21 with the reduced widths. The etchant used for the etching is preferably chosen such that the etch rate for the semiconductor material of the semiconductor body 1 is greater than for the mask material and/or for the material of the first auxiliary layer 4 and/or the material of the second auxiliary layer 3.

The trenches 5 extend from the top side 10 through the contact regions 12 and the channel regions 11 and are deeper than the channel regions 11. The trenches 5 each divide the previously contiguous contact regions 12 and channel regions 11 into two contact regions 12 and two channel regions 11 which adjoin the respective trench 5 at both sides with respect to the first lateral direction Q. By way of example, the depths of the etched trenches 5 are 1 µm or less.

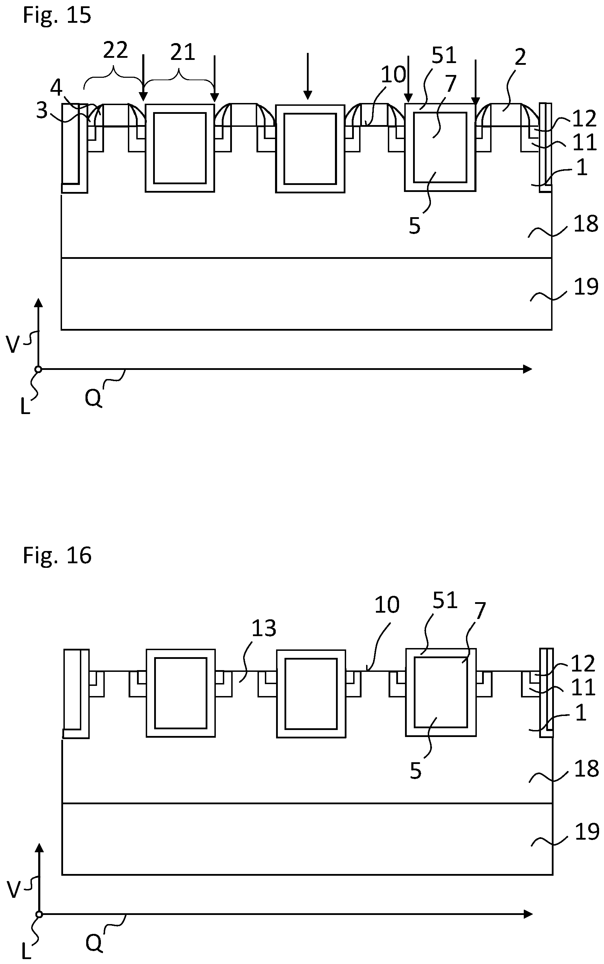

Figure 15 shows a position of the method in which an electrically insulating layer 51 is formed at the surfaces of the trenches 5. The electrically insulating layer 51 is, for example, formed by oxidation of the surfaces of the trenches 5. Additionally, a gate electrode 7 is formed in the trenches 5.

In the position of figure 16, the second mask 2 and the rest of the auxiliary layers 3, 4 on the lateral sides 22a of the second sections 22 are removed. With this, the top side 10 of the semiconductor body 1 is exposed in the area between the trenches 5. Between each pair of trenches 5, the top side 10 is partially formed by two contact regions 12, two channel regions 11 and a diode region 13. The contact regions 12 are thereby embedded in the channel regions 11 such that the contact regions 12 and the channel regions 11 adjoin a trench 5 but are electrically isolated from the gate electrode 7 in the trench 5 by means of the electrically isolating layer 51. The diode regions 13 are formed by the drift layer 18 and, therefore, are n-doped.

Due to the method described herein, only one lithography step is needed to produce the channel regions 11, the contact regions 12 and the trenches 5. Such a self-aligned process allows very small structures to be produced. The distance between two adjacent trenches 5, measured in the first lateral direction Q is, e.g., at most 3 times the depths of the trenches 5. For example, the distance is at most 3 µm. The width of each of contact regions 12, measured in the first lateral direction Q, is, for example, at most 1 µm or at most 500 nm.

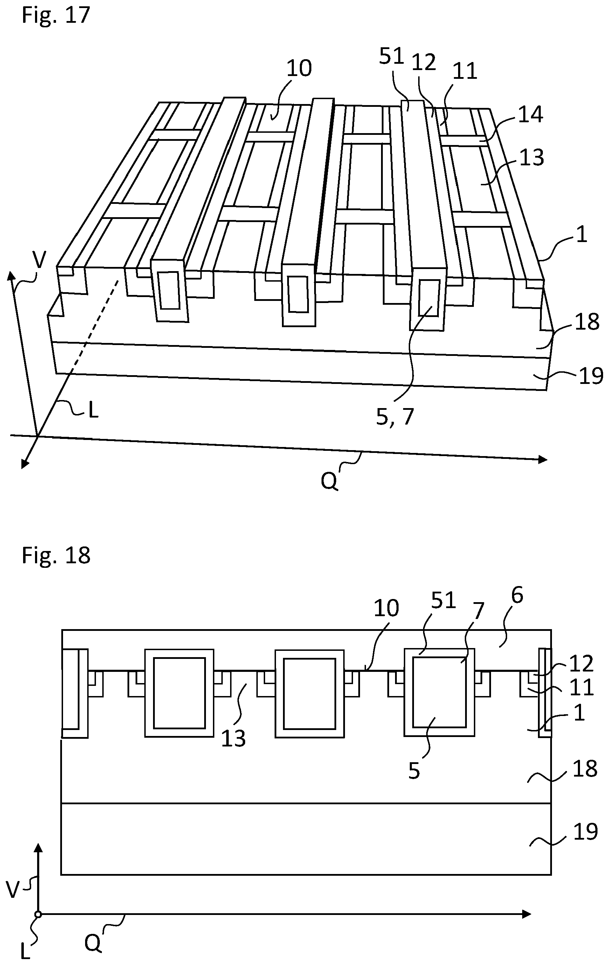

Figure 17 shows the semiconductor body 1 of figure 16 in a perspective view so that the location of the trenches 5, the contact regions 12, the channel regions 11, the diode regions 13 and the plug regions 14 with respect to each other is visible. The plug regions 14 extend obliquely to the trenches 5 and adjoin the top side 10 in areas which were previously covered by the second sections 22 of the mask 2.

In the position of figure 18, a first main electrode 6 is applied onto the top side 10 of the semiconductor body 1. The main electrode 6 adjoins the semiconductor body 1 in the area between the trenches 5 and is in direct contact with the contact regions 12, the channel regions 11 and the diode regions 13. The first main electrode 6 is, e.g., formed of metal. It is electrically isolated from the gate electrode 7 by means of the electrically isolating layer 51.

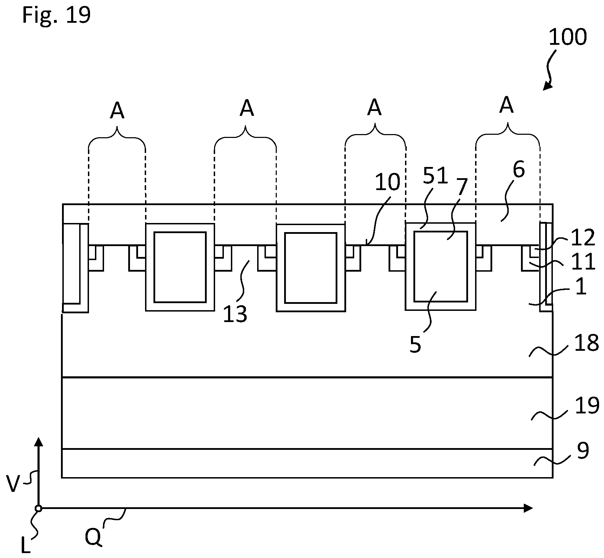

Figure 19 shows the finalized semiconductor device 100. The semiconductor device 100 is, e.g., a power semiconductor device, like a power MOSFET. On the bottom side of the semiconductor body 1, opposite to the top side 10, a second main electrode 9 is applied. The first main electrode 6 is a source electrode and the second main electrode 9 is a drain electrode.

The plug regions 14 are, for example, used for electrically contacting the channel regions 11. Due to the high doping concentration of the plug regions 14, an ohmic contact may be formed between the plug regions 14 and the first main electrode 6. The plug regions 14 are, on the other hand, electrically connected to the channel regions 11 so that, in the end, channel regions 11 are electrically well connected to the first main electrode 6.

During operation a voltage difference is applied between the first main electrode 6 and the second main electrode 9, which is, for example, more than one 1kV. In forward operation of the MOSFET, an electrical current flowing between the main electrodes 6, 9 is controlled by the gate electrode 7. In conduction mode, electrons are injected from the first main electrode 6 into the contact region 12. From there, the electrons pass through the channel regions 11 down along the trenches 5 and into the drift layer 18 from which they flow to the second main electrode 9. The diode region 13, together with the first main electrode 6, form a Schottky diode which is blocking in the conduction mode.

Thus, a charge carrier flow mainly happens in the area between the trenches 5, which is why this area is herein called active area A. With the method described herein, very small structures of the active area A can be produced.

The embodiments shown in the Figures 1 to 19 as stated represent exemplary embodiments of the improved method for producing a semiconductor device and the improved semiconductor device; therefore, they do not constitute a complete list of all embodiments according to the improved method and the improved semiconductor device. Actual methods and devices may vary from the embodiments shown in terms of elements, order of method steps and so on.

### Reference Signs

- 1: semiconductor body
- 2: (second) mask
- 3: (second) auxiliary layer
- 4: first/further auxiliary layer
- 5: hole
- 6: (first) main electrode
- 7: gate electrode
- 8: first/further mask
- 9: second main electrode
- 10: top side
- 11: channel region
- 12: contact region
- 13: diode region
- 14: plug region
- 18: drift layer
- 19: substrate
- 21: first section
- 22: second section
- 22a: lateral side of the second section 22
- 51: electrically isolating layer
- 81: first section of mask 8
- 82: second section of mask 8
- 100: semiconductor device
- Si: method step
- Q: first lateral direction
- L: second lateral direction
- V: vertical direction

## Claims

1. Method for producing a semiconductor device, comprising
- providing a semiconductor body (1) with a top side (10),
- applying a mask (2) on the top side (10), wherein
- the mask (2) comprises at least one first section (21) and at least one second section (22) laterally adjacent to the at least one first section (21),
- the mask (2) is thicker in the at least one second section (22) than in the at least one first section (21),
- forming a channel region (11) of a first conductivity type in the semiconductor body (1) in the area of the at least one first section (21), wherein
- forming the channel region (11) comprises implanting first-type dopants through the top side (10) into the semiconductor body (1),
- depositing an auxiliary layer (3) on a lateral side (22a) of the at least one second section (22) facing towards the at least one first section (21) which increases the lateral extension of the at least one second section (22) and reduces the lateral extension of the at least one first section (21),
- producing a hole (5) in the semiconductor body (1) in the area of the at least one first section (21) with the reduced lateral extension so that the hole (5) extends from the top side (10) through the channel region (11).

2. Method according to claim 1, wherein
- after forming the channel region (11) and before depositing the auxiliary layer (3), a further auxiliary layer (4) is deposited on the lateral side (22a) of the at least one second section (22) which increases the lateral extension of the at least one second section (22) and reduces the lateral extension of the at least one first section (21),
- after depositing the further auxiliary layer (4) and before depositing the auxiliary layer (3), a contact region (12) of a second conductivity type is formed in the semiconductor body (1) in the area of the first section (21) so that the contact region (12) lies between the channel region (11) and the top side (10), wherein the formation of the contact region (12) comprises implanting second-type dopants through the top side (10) into the semiconductor body (1),
- the hole (5) is formed through the contact region (12).

3. Method according to claim 1 or 2, wherein
- the auxiliary layer (3) is deposited by a conformal deposition process so that the lateral side (22a) of the at least one second section (22), a top side of the at least one second section (22) and the area of the first section (21) are covered by the auxiliary layer (3),
- then, a directed material removal process is applied by which the auxiliary layer (3) is removed more in the area of the first section (21) and at the top side of the second section (22) than at the lateral side (22a) of the second section (22).

4. Method according to any one of the preceding claims, wherein
- before applying the mask (2), the semiconductor body (1) is of the second conductivity type at least at the top side (10),
- during implantation of the first-type dopants, the at last one second section (22) protects the semiconductor body (1) below from the first-type dopants so that the semiconductor body (1) remains of the second conductivity type at the top side (10) in the area of the at least one second section (22) .

5. Method according to any one of the preceding claims, further comprising
- forming an electrically isolating layer (51) at surfaces of the hole (5),
- forming a gate electrode (7) on and/or in the at least one hole (5) such that the gate electrode (7) is electrically isolated from the semiconductor body (1) by the electrically isolating layer (51),
- removing the mask (2),
- forming a main electrode (6) on the top side (10) so that the main electrode (6) adjoins and is electrically connected to the semiconductor body (1) in the area laterally adjacent to the at least one hole (5).

6. Method according to claim 5 in its dependency on claim 4, wherein
- the main electrode (6) adjoins at least one diode region (13) of the semiconductor body (1) being of the second conductivity type at the top side (10).

7. Method according to any one of the preceding claims, wherein
- before applying the mask (2), a further mask (8) is applied onto the top side (10) of the semiconductor body (1),
- at least one plug region (14) being of the first conductivity type is formed in the semiconductor body (1) with help of the further mask (8), wherein the at least one plug region (14)
- adjoins the top side (10),
- is at least partially formed in the area of the top side (10) which is subsequently covered by the at least one second section (22) of the mask (2),
- the doping concentration in the at least one plug region (14) is greater than in the channel region (11).

8. Method according to any one of the preceding claims, wherein
- the mask (2) comprises a plurality of stripe-like first sections (21) and a plurality of stripe-like second sections (22),
- a channel region (11) and a hole (5) are formed in the area of several of the first sections (21), wherein each channel region (11) is formed stripe-like and each hole (5) is formed as a trench.

9. Method according to claim 8 in its dependency on claim 7, wherein
- a plurality of plug regions (14) is formed,
- each plug region (14) is formed stripe-like,
- the plug regions (14) extend obliquely to the channel regions (11).

10. Semiconductor device (100) comprising
- a semiconductor body (1) with a top side (10), wherein
- at least one hole (5) extends from the top side (10) into the semiconductor body (1),
- the at least one hole (5) delimits an active area (A) of the semiconductor body (1) in a first lateral direction (Q),
- the active area (A) comprises at least one channel region (11) being of a first conductivity type and at least one contact region (12) being of a second conductivity type,
- the at least one channel region (11) and the at least one contact region (12) adjoin the at least one hole (5) in the first lateral direction (Q),
- the at least one contact region (12) is embedded in the at least one channel region (11) such that in vertical direction (V), perpendicular to the top side (10), the at least one contact region (12) is arranged between the top side (10) and the at least one channel region (11) and such that the at least one contact region (12) adjoins the top side (10),
- the width of the active area (17) measured in the first lateral direction (Q) is at most 3 times as great as the depth of the at least one hole (5) measured in vertical direction (V).

11. Semiconductor device (100) according to claim 10, wherein
- the width of the active area (A) is at most 3 µm.

12. Semiconductor device (100) according to claim 10 or 11, further comprising
- a main electrode (6) on the top side (10) in the active area (A), wherein
- the active area (A) comprises at least one diode region (13) which is of the second conductivity type,
- the at least one diode region (13) adjoins the top side (10),
- the main electrode (6) adjoins and is in electrical contact with the at least one contact region (12) and the at least one diode region (13).

13. Semiconductor device (100) according to claim 12, wherein
- surfaces of the at least one hole (5) are at least partially covered by an electrically isolating layer (51),
- a gate electrode (7) is formed on and/or in the at least one hole (5) and is electrically isolated from the semiconductor body (1) by the isolating layer (51).

14. Semiconductor device (100) according to any one of claims 10 to 13, wherein
- the active area (A) comprises at least one plug region (14) which is of the first conductivity type and which adjoins the top side (10),
- the at least one plug region (14) has a higher doping concentration than the at least one channel region (11).

15. Semiconductor device (100) according to any one of claims 10 to 14, wherein
- the semiconductor device (100) is a power semiconductor device,
- the semiconductor device (100) comprises a plurality of holes (5) each formed as a trench, wherein the trenches (5) are spaced apart from each other in the first lateral direction (Q) and each trench (5) extends in a second lateral direction (L),
- the semiconductor device (100) comprises a plurality of active areas (A), each one arranged between a pair of trenches (5),
- each active area (A) comprises at least two elongated channel regions (11) extending in the second lateral direction (L) and at least two elongated contact regions (12) extending in the second lateral direction (L),
- the channel regions (11) and the contact regions (12) of each active area (A) each adjoin a trench (5) delimiting the active area (A),
- the width of an active area (A) is the distance between the two trenches (5) delimiting the active area (A) in the first lateral direction (Q).
